Europäisches Patentamt

European Patent Office

Office européen des brevets

(19)

(11) **EP 0 626 754 B1**

(12) **FASCICULE DE BREVET EUROPEEN**

(45) Date de publication et mention
de la délivrance du brevet:
**22.07.1998 Bulletin 1998/30**

(51) Int Cl.⁶: **H03C 1/50**

(21) Numéro de dépôt: **94401173.3**

(22) Date de dépôt: **27.05.1994**

(54) **Procédé et dispositif de modulation en amplitude d'un signal radiofréquence**

Verfahren und Einrichtung zur Amplitudenmodulierung eines Radiofrequenzsignals

Method and arrangement for amplitude modulating of a radio frequency signal

(84) Etats contractants désignés:
CH DE GB LI

(30) Priorité: **28.05.1993 FR 9306420**

(43) Date de publication de la demande:
**30.11.1994 Bulletin 1994/48**

(73) Titulaire: **THOMSON-CSF**
**75008 Paris (FR)**

(72) Inventeurs:
• **Linguet, Laurent**
**F-92402 Courbevoie Cédex (FR)**
• **De Boisriou, Philippe**
**F-92402 Courbevoie Cédex (FR)**

(74) Mandataire: **Lincot, Georges et al**
**THOMSON-CSF-S.C.P.I.,**
**13, Avenue du Président**
**Salvador Allende**
**94117 Arcueil Cédex (FR)**

(56) Documents cités:
**EP-A- 0 083 727**      **US-A- 4 584 541**
**US-A- 4 835 493**

## Description

La présente invention concerne un procédé et un dispositif de modulation en amplitude d'un signal radiofréquence.

Elle s'applique notamment aux émetteurs de radiodiffusion en ondes moyennes comportant des modules de puissance à transistors à effet de champs ou de type MOSFET selon la terminologie anglo-saxonne.

Avec l'avènement des transistors de puissance, faciles à commander et à faible temps de commutation donc capables de fonctionner à des fréquences de quelques centaines de kilohertz à un mégahertz ou plus, les émetteurs à tube électronique, coûteux, encombrants, nécessitant des alimentations très haute tension et de maintenance difficile tendent à être remplacés par des émetteurs dont les étages amplificateurs utilisent ces types de transistors. Ces émetteurs sont en général composés de modules ou amplificateurs élémentaires de puissance, assemblés en parallèle ou en série de façon à émettre la puissance requise. L'architecture usuelle de ces modules est de type pont en "H" encore appelé "pont complet". Il existe actuellement plusieurs solutions de modulation en amplitude du signal de sortie de ces émetteurs. L'une est décrite par la demande de brevet n°2 567 338 intitulée "Amplificateur à étages d'amplification commutables en fonction de l'amplitude du signal à amplifier" déposée en France au nom de la Demanderesse.

Cette solution est relativement simple à mettre en oeuvre et ne demande pas de gestion particulière du fonctionnement des modules élémentaires. Néanmoins elle nécessite beaucoup de selfs inductances et de condensateurs dimensionnés pour des circuits et tensions importants, ainsi que des transformateurs avec de nombreux secondaires, c'est donc une solution coûteuse encombrante et de médiocre rendement.

Une autre solution comprenant une gestion numérique des modules permet une amélioration du rendement mais au prix d'une grande complexité de gestion des modules. Dans ce cas, la constitution de l'enveloppe de l'onde émise s'effectue par superposition du signal fourni par chacun des modules de puissance alimentés sous une même tension E et dont le fonctionnement est commandé par la partie numérique. Cependant pour affiner l'enveloppe du signal à émettre, il est nécessaire d'utiliser des modules de puissance supplémentaires alimentés sous tension E/2, E/4...E/2p. Cela constitue un inconvénient majeur puisque tous les modules élémentaires ne sont plus identiques et supprime ainsi l'interchangeabilité totale de ces modules. Cela ne permet pas non plus un mode de fonctionnement en puissance dégradée ou diminuée, puisque la mise hors circuit d'au moins un module, suite à une avarie quelconque, entraîne des distorsions de l'onde émise contrairement à une solution composée de modules interchangeables dont l'arrêt de l'un ou l'autre n'entraîne qu'une diminution de puissance émise, or, bien souvent dans certains cas de figures, un tel mode de fonctionnement peut rester satisfaisant pour l'utilisation.

Par ailleurs cette solution exige beaucoup de sources de tensions différentes et les commutations continuelles des modules engendrent des signaux parasites perturbants. Il est à noter de plus que l'absence d'interchangeabilité totale des modules entraîne une difficulté et un coût supplémentaires de maintenance et de mise au point.

Le but de l'invention est de pallier les inconvénients précités.

A cet effet, l'invention a pour objet un procédé de modulation en amplitude d'un signal, du type consistant à moduler un signal radiofréquence de sortie d'un nombre déterminé de modules amplificateurs à transistors, par un signal de modulation, caractérisé en ce qu'il consiste à décomposer le signal radiofréquence à moduler suivant au moins un premier et un deuxième signal, représentant respectivement la somme des tensions de sorties d'amplitudes respectives identiques d'un premier et d'un deuxième nombre déterminé de modules, auxquels sont associés respectivement un premier et un deuxième vecteur dont les amplitudes et les phases respectives vérifient que la somme vectorielle des deux vecteurs coïncide avec une référence déterminée servant de référence de phase des deux vecteurs, et à moduler les phases respectives des deux signaux par le signal de modulation et à additionner le premier et le deuxième signal modulés en phase pour obtenir après filtrage un signal résultant modulé en amplitude.

L'invention a pour principaux avantages qu'elle permet à tous les modules amplificateurs de l'émetteur de fonctionner dans un mode unique de commutation de blocage. Ceci permet de ne plus générer de pertes dues aux capacités de sortie MOSFET gênantes en mode de commutation d'amorçage et donc d'améliorer le rendement global de l'émetteur. L'invention permet, d'autre part, une grande souplesse du contrôle de la puissance de sortie, une meilleure précision de l'amplitude du signal de sortie en fonction du signal de modulation à l'entrée de l'émetteur. Elle permet par ailleurs une maintenance aisée et un mode de fonctionnement en puissance dégradée.

D'autres caractéristiques et avantages de l'invention apparaîtront plus clairement à l'aide de la description qui suit faite en regard des dessins annexés qui représentent:

- la figure 1, un diagramme vectoriel de Fresnel, illustrant le principe du procédé selon l'invention,
- la figure 2, une configuration d'un module amplificateur élémentaires, et
- la figure 3, un mode de réalisation d'un dispositif pour la mise en oeuvre du procédé selon l'invention.
- la figure 4, un mode de répartition des commandes des amplificateurs élémentaires.

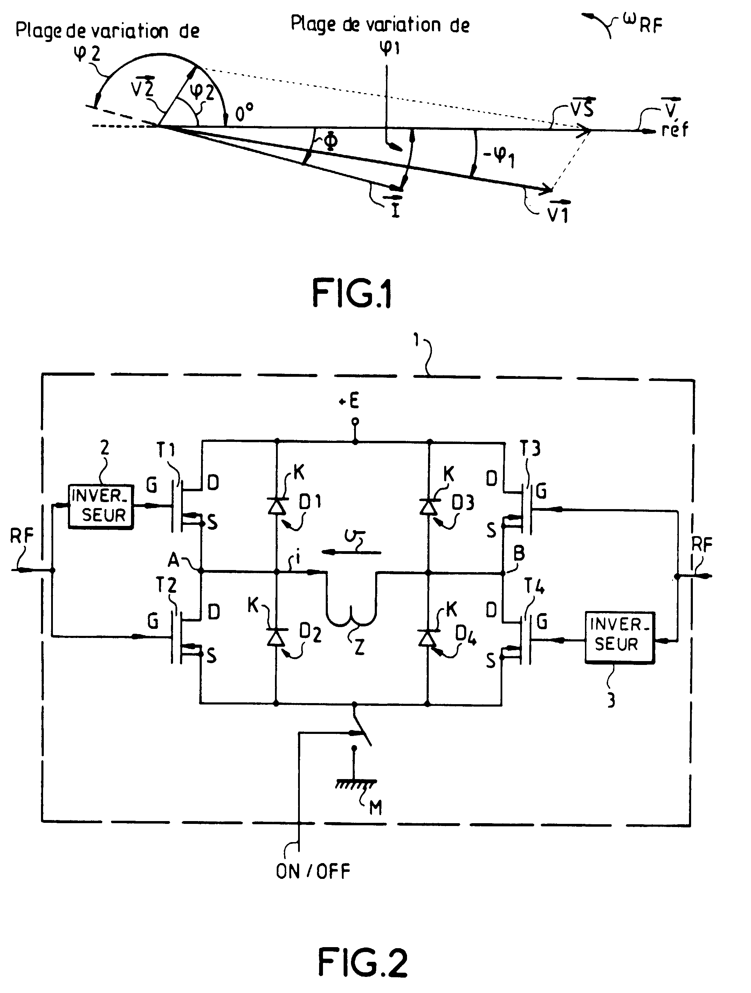

La figure 1 illustre le principe de base du procédé selon l'invention.

Sur cette figure les vecteurs $\vec{V}_1$ et $\vec{V}_2$ constituent une représentation vectorielle suivant la méthode de Fresnel de deux signaux sinusoïdaux de même fréquence f et déphasés respectivement d'un angle $-\varphi_1$ et $\varphi_2$ déterminé par rapport à un signal de référence déterminé $\vec{V}_{ref}$ de même fréquence f.

L'amplitude des vecteurs $\vec{V}_1$ et $\vec{V}_2$ peut être différente. Leur amplitude respective est notée $E_1$ et $E_2$. Une fonction du temps du premier signal et du deuxième signal associés respectivement aux vecteurs $\vec{V}_1$ et $\vec{V}_2$ peut être notée :

$$(1) \qquad V_1(t) = E_1 \cos(2\pi ft - \varphi_1)$$

et

$$(2) \qquad V_2(t) = E_2 \cos(2\pi ft + \varphi_2)$$

où t représente le temps, $E_1$, $E_2$, $\varphi_1$ et $\varphi_2$ les amplitudes et les phases précitées.

Les vecteurs $\vec{V}_1$ et $\vec{V}_2$ sont associés respectivement à la somme des tensions de sortie, d'un premier et d'un deuxième nombre déterminé de modules amplificateurs élémentaires définissant respectivement un premier et un deuxième groupe de modules amplificateurs. Les modules sont identiques et les tensions de sortie de chaque module d'un même groupe sont identiques. Les amplitudes $E_1$ et $E_2$ représentent respectivement la somme des amplitudes des tensions de sortie de chaque module du premier et du deuxième groupe de modules.

Les valeurs des amplitudes $E_1$ et $E_2$ et des phases $\varphi_1$ et $\varphi_2$ des deux signaux $V_1(t)$ et $V_2(t)$ sont déterminées de façon à ce que le signal somme $V_S$ des deux signaux $V_1(t)$ et $V_2(t)$ associé à la somme vectorielle $\vec{V}_S$ des deux vecteurs $\vec{V}_1$ et $\vec{V}_2$ respectivement associés aux signaux $V_1(t)$ et $V_2(t)$, soit en phase avec un signal de référence déterminé auquel est associé le vecteur $\vec{V}_{réf}$.

L'amplitude maximale du signal somme $V_S$ s'exprime alors selon l'expression suivante :

$$(3) \qquad |V_S| = E_1 \cos\varphi_1 + E_2 \cos\varphi_2$$

La modulation en amplitude du signal somme $V_S$ est donc réalisée en agissant sur tout ou partie des quatre paramètres respectifs aux amplitudes $E_1$, $E_2$ et aux phases $\varphi_1$ et $\varphi_2$ des deux signaux $V_1(t)$ et $V_2(t)$.

D'autre part l'impédance de charge Z sur laquelle débite les modules amplificateurs est adaptée de façon à ce que le courant de charge I de tous les modules soit toujours en retard de phase φ par rapport à leur tension de sortie $\vec{V}_1$ ou $\vec{V}_2$.

Ces conditions de fonctionnement permettent aux transistors de fonctionner dans un mode unique de commutation de blocage et permettent ainsi de s'affranchir de la présence d'une diode série avec les transistors MOSFET nécessaire dans le cas d'une commutation d'amorçage et qui génère des pertes. Le procédé selon l'invention permet donc d'améliorer le rendement global de l'émetteur.

Le procédé selon l'invention consiste enfin à additionner les deux signaux $\vec{V}_1$ et $\vec{V}_2$ pour obtenir un signal $V_S(t)$ modulé en amplitude en agissant sur les paramètres amplitude et phase de chaque signal $\vec{V}_1$ et $\vec{V}_2$.

Un exemple de module amplificateur élémentaire 1 utilisé par le procédé selon l'invention est illustré par la figure 2.

Une structure symétrique de pont formant un "H", comporte deux paires de transistors MOSFET identiques, $T_1$ à $T_4$, fonctionnant chacun en régime de commutation. Chaque MOSFET, $T_1$ à $T_4$, se comporte comme un interrupteur actif.

Chaque paire de transistors comporte respectivement un premier et un deuxième transistor en série $T_1$, $T_2$ et $T_3$, $T_4$. La source S du premier transistor de chaque paire $T_1$, $T_3$ étant couplée au drain D du deuxième $T_2$, $T_4$. L'alimentation continue d'amplitude déterminée E est appliquée sur les drains D des deux premiers MOSFET, $T_1$ et $T_3$, de chaque paire et le circuit ainsi réalisé est refermé sur un potentiel de masse M par l'intermédiaire d'une commande ON/OFF symbolisée par un interrupteur, servant de référence de potentiel, par les sources des deuxièmes transistors MOSFET, $T_2$ et $T_4$, de chaque paire. Des diodes, $D_1$ à $D_4$, sont montées en parallèle respectivement sur chaque transistor MOSFET, $T_1$ à $T_4$, entre leur drain D et leur source S respectives. La cathode K est couplée au drain D et l'anode à la source S.

Le signal de sortie v du pont en "H" est délivré entre la sortie de chaque paire de transistors $T_1$, $T_2$ et $T_3$, $T_4$ c'est-à-dire entre les points communs entre la source S et le drain D des deux paires de transistors $T_1$, $T_2$, et $T_3$, $T_4$, représentés respectivement par les points A et B. Le pont débite un courant i dans une impédance de charges déterminée Z représentée sous la forme d'un primaire de transformateur. Chaque transistor $T_1$ à $T_4$ reçoit un signal de commande RF sur sa grille G. Un des deux transistors $T_1$, $T_2$ et $T_3$, $T_4$ de chaque paire reçoit le signal de commande RF directement et l'autre transistor reçoit le même signal mais inversé par un circuit inverseur 2 et 3, réalisé par exemple à partir d'un transformateur dont le bobinage de l'enroulement du secondaire côté transistor est inversé par rapport à l'enroulement du primaire recevant le signal de commande RF. D'autre part les premiers transistors $T_1$ et $T_3$ de chaque paire reçoivent respectivement le même signal de commande mais inversé, de même pour les deuxièmes transistors de chaque paire $T_2$ et $T_4$.

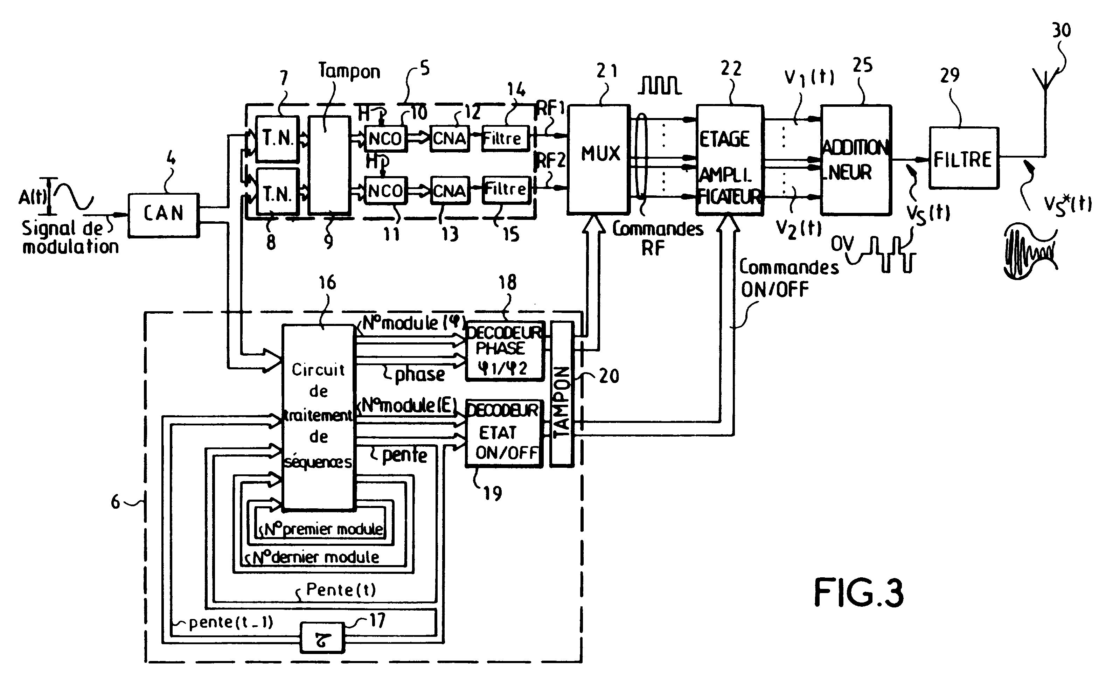

Un dispositif pour la mise en oeuvre du procédé selon l'invention est représenté par la figure 3.

Ce dispositif comporte un convertisseur analogique-numérique, 4 connu sous l'abréviation CAN recevant sur son entrée un signal de modulation A(t), un signal audiofréquence quelconque par exemple, dont l'amplitude maximale est connue et est utilisée pour calibrer le dispositif. Une allure du signal de modulation A(t) est représentée sur la figure 3. Le CAN 4 délivre sur sa sortie le signal de modulation converti numériquement. La fréquence de conversion est égale à une fréquence d'émission déterminée f ou à une de ses fréquences multiples. La sortie du CAN 4 est couplée, respectivement, sur les deux entrées d'un étage générateur de commandes 5 et sur l'entrée de moyens de gestion 6.

L'étage générateur de commandes 5 comporte de l'entrée vers la sortie, un premier circuit 7 et un deuxième circuit 8 de traitement numérique, désignés par les initiales T.N. sur la figure 3, recevant chacun sur leur entrée le signal de modulation converti numériquement. Chaque circuit de traitement numérique 7 et 8 génère respectivement un déphasage déterminé $\varphi_1$ et $\varphi_2$ en fonction de l'amplitude du signal de modulation A(t). La variation de l'amplitude du signal de modulation A(t) en fonction du temps conditionne une loi prédéterminée de variation des paramètres d'amplitude $E_1$ et $E_2$ et de phase $\varphi_1$ et $\varphi_2$ des signaux de sortie $V_1(t)$ et $V_2(t)$ des modules amplificateurs. Les paramètres peuvent être aussi eux-mêmes définis par une fonction prédéterminée du temps, l'ensemble de ces fonctions prédéterminées devant obéir à la loi de variation imposée par la variation de l'amplitude du signal de modulation pour pouvoir reconstituer le signal de modulation.

Le signal de modulation A(t) peut être reconstitué à partir de fonctions déterminées des paramètres d'amplitude et de phase des signaux de sortie des modules amplificateurs et peut s'exprimer par exemple par la formule suivante :

$$(4) \qquad A(t)=f_3(t)\cos f_1(t)+f_2(t)\cos f_4(t)$$

avec par exemple:
$f_3(t)=E_1$, $f_1(t)=\varphi_1, f_2(t)=E_2$
et $f_4(t)=\varphi_2$ où $f_1(t)$ à $f_4(t)$ sont des constantes.
Les différentes fonctions $f_1(t)$ à $f_4(t)$ peuvent également prendre en compte différents critères fixés par l'utilisateur tels que par exemple, le nombre de modules utilisés, le déphasage $\phi$ maximal de l'impédance de charge Z etc...

La sortie de chaque circuit de traitement numérique 7 et 8 délivre donc respectivement une valeur déterminée de déphasage $\varphi_1$ et $\varphi_2$ déduite d'une loi et de fonctions prédéterminées, du type par exemple de la relation (4), en fonction de la variation de l'amplitude du signal de modulation A(t). Les circuits de traitement numérique 7 et 8 peuvent être réalisés par exemple au moyen de mémoires comportant des tables de circuits logiques programmables par l'utilisateur. Les valeurs de déphasage $\varphi_1$ et $\varphi_2$, ou données de modulation de phase, sont appliquées à l'entrée d'un premier registre tampon 9 qui synchronise les données de modulation entre elles.

Elles sont ensuite injectées respectivement sur l'entrée d'un premier et d'un deuxième oscillateur numérique NCO, 10 et 11, abréviation anglo-saxonne pour "Numerically Controled Oscillator". Chaque NCO 10 et 11 délivre, à partir d'un même signal déterminé d'horloge H, un signal numérique périodique variant sinusoïdalement à la même fréquence que la fréquence d'émission f du signal à moduler, et dont la phase varie suivant la donnée de modulation présente à leur entrée.

La sortie de chaque NCO 10 et 11 est couplée respectivement à l'entrée d'un convertisseur numérique analogique ou CNA, 12 et 13, et les signaux analogiques délivrés en sortie de chaque CNA, 12 et 13, sont filtrés respectivement par un filtre 14 et 15, par exemple de type Butterworth. L'étage générateur de commandes 5 délivre donc deux signaux de même fréquence égale à la fréquence d'émission f qui constituent respectivement un premier et un deuxième signal de commande RF1 et RF2 des transistors MOSFET d'un premier nombre déterminé N1 de modules 1 dont la somme des signaux de sortie $V_1(t)$ est déphasé de $-\varphi_1$ et d'un deuxième nombre N2 déterminé de modules 1 dont la somme des signaux de sortie $V_2(t)$ est déphasée de $+\varphi_2$ en reprenant le cas représenté à la figure 1.

Les moyens de gestion 6 reçoivent sur leur entrée, correspondant également à une première entrée d'un circuit de traitement de séquences 16, le signal de modulation converti numériquement par le CAN 4. Ce circuit 16 est réalisé par exemple à partir d'une mémoire programmable par l'utilisateur.

Le signal de modulation A(t) est décomposé par le circuit de traitement de séquences 16 en un nombre déterminé de séquences assimilées à des bandes horizontales qui sont juxtaposées pour reconstituer le signal de modulation A(t). Chaque séquence correspond à une portion du signal de modulation A(t) pris entre les deux instants consécutifs déterminés.

L'information de niveau peut être par exemple déterminée à partir des bits de poids fort du mot binaire traduisant une amplitude déterminée du signal de modulation A(t) à un instant déterminé.

Le circuit de traitement de séquences 16, détermine également le sens de variation, ou pente, du signal de modulation A(t) en comparant la donnée de modulation entre deux séquences consécutives, soit entre deux instants de décision consécutifs déterminés, t-1 et t, un changement de pente se traduisant par un changement d'état d'un bit de signe déterminé.

A chaque instant de décision, le circuit de traitement de séquence 16 transmet un changement d'état d'un ou de plusieurs modules déterminés ainsi que la phase à appliquer à ces modules en fonction du niveau d'amplitude et de la pente du signal de modulation A(t).

Le circuit de traitement de séquences 16 délivre en sortie un nombre déterminé d'informations qui sont réinjectées sur son entrée :

- une première information correspond à l'identification du premier module activé dans le cas d'une croissance du signal de modulation ou du premier module désactivé dans le cas d'une décroissance du signal de modulation,
- une deuxième information correspond à l'identification du dernier module activé avant un changement de pente du signal de modulation, et
- une troisième et quatrième information correspondent respectivement à la pente du signal de modulation à l'instant courant t et la pente du signal de modulation à l'instant précédent t-1, les deux instants t et t-1 étant séparés d'un retard τ 17.

Le circuit de traitement de séquence 16 détermine en outre les différentes associations entre les signaux RF1, RF2 générés par l'étage générateur de commandes 5 et un ou plusieurs modules déterminés en fonction de la loi prédéterminée fixée par la variation de l'amplitude du signal de modulation A(t) du type de la formule (4). Il permet également une répartition des modules activés afin d'uniformiser la dissipation thermique globale sur tous les modules amplificateurs.

Pour cela il délivre sur sa sortie un premier couple d'informations respectives à l'identification du module élu, et à la phase à appliquer sur ce module. De même il délivre sur sa sortie un deuxième couple d'informations respectives à l'identification du module élu et à la pente du signal de modulation A(t).

Les premier et deuxième couples d'informations sont injectés respectivement à l'entrée d'un décodeur de phase 18 et d'un décodeur d'état ON/OFF 19.

Le décodeur de phase 18 reçoit un premier mot de commande identifiant le module déterminé, codé par exemple sur six bits, et reçoit une commande de sélection de la phase $\varphi_1$ ou $\varphi_2$ à appliquer à ce module, codée sur un bit, état "0" pour $\varphi_1$ et état "1" pour $\varphi_2$ par exemple. Il permet de transcrire les informations reçues en un signal de commande de multiplexage.

Le décodeur d'état ON/OFF 19 permet de transcrire l'identification d'un module déterminé et la pente du signal de modulation à l'instant de décision en un ordre d'activation ON ou de non activation OFF de ce module. Les informations issues des deux décodeurs 18 et 19 sont synchronisées par un circuit tampon 20, puis sont injectées respectivement sur une première entrée d'un multiplexeur MUX 21 et sur un étage amplificateur 22.

Le multiplexeur 21 établit les différentes connexions entre les signaux de commande RF1, RF2 et les modules élus de l'étage amplificateur 22. L'allure des signaux de commande RF1 et RF2 est illustrée sur la figure 3.

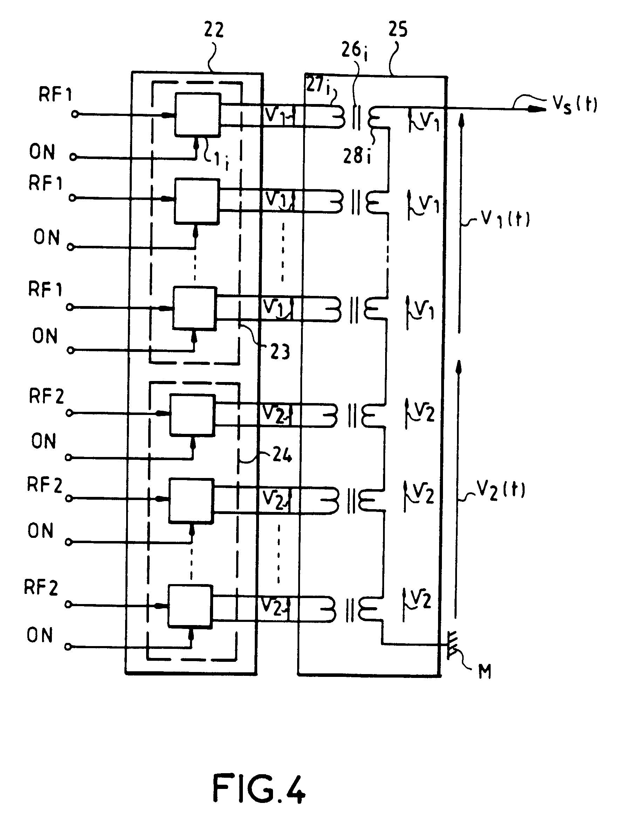

La figure 4 représente un exemple de répartition des commandes RF1 et RF2 sur un premier et un deuxième groupe 23 et 24 de modules 1i, du type illustré par la figure 2, de l'étage amplificateur 22. Chaque module 1i du premier et du deuxième groupe 23 et 24 de modules est activé par une première commande d'activation ON et par une deuxième commande, RF1 pour le premier groupe 23 de modules et RF2 pour le deuxième groupe 24 de modules. Chaque module 1i de chaque groupe 23 et 24 délivre respectivement sur sa sortie une tension $v_1(t)$ et une tension $v_2(t)$.

Les tensions $v_1(t)$ et $v_2(t)$ sont additionnées par un additionneur 25 réalisé par exemple à partir de transformateurs 26i de rapport de transformation égal à un. Chaque transformateur 26i reçoit sur son primaire 27i la tension $v_1(t)$ ou $v_2(t)$ qui est ensuite recueillie aux bornes du secondaire 28i du transformateur 26i. Les secondaires 28i de tous les transformateurs 26i sont câblés en série et refermés, par une première extrémité, sur un potentiel de masse M servant de potentiel de référence, et délivrent sur une deuxième extrémité le signal $V_S(t)$ constitué de la somme des tensions $v_1(t)$ et des tensions $v_2(t)$

Le signal de sortie $V_S(t)$ de l'additionneur 25 est injecté à l'entrée d'un filtre passe-bas 29 qui sert également d'adaptateur d'impédance représenté sur la figure 3.

Le signal de sortie $V_S(t)$ est un signal carré comportant des créneaux symétriques par rapport à une tension de 0V dont l'allure est représentée sur la figure 3. Le filtre 29 restitue sur sa sortie un signal $V_S^*(t)$ correspondant à l'harmonique principale, ou fondamentale, du signal $V_S(t)$. Une variation de la largeur des créneaux et de leur amplitude se traduit en sortie du filtre 29 par une variation de l'amplitude du signal $V_S^*(t)$, l'enveloppe du signal $V_S^*(t)$ correspondant au signal de modulation A(t). Le signal $V_S^*(t)$ est ensuite transmis à une antenne d'émission radiofréquence 30.

Le dispositif selon l'invention permet donc de moduler en amplitude un signal radiofréquence en modulant en phase les signaux de sorties des deux groupes 23 et 24 de modules.

Le bon choix des valeurs d'amplitude et de déphasage des tensions de sortie des modules amplificateurs ainsi que la phase de l'impédance de charge des modules permet d'imposer un courant débité par chaque module toujours en retard de phase sur la tension de sortie de chaque module.

Une variante de l'invention consiste à dissocier les commandes RF des paires de transistors $T_1$, $T_2$ et $T_3$, $T_4$ des modules amplificateurs 1. Le signal RF se décompose, par exemple, en un premier signal RF1 et en deuxième signal RF2. Un même module amplificateur est ainsi décomposé en deux modules amplificateurs constitué chacun par un demi pont.

L'invention n'est pas limitée à la description précise précédente. Le nombre de groupes de modules amplificateurs n'est pas limité à deux, et l'utilisation de plus de deux groupes de modules ne sort pas du cadre de l'invention si les conditions imposées sur le déphasage et l'amplitude des vecteurs associés aux signaux de sortie des modules ainsi que sur l'impédance de charge sont respectées.

## Revendications

1. Procédé de modulation en amplitude d'un signal, du type consistant à moduler un signal radiofréquence de sortie ($V_S$(t)) d'un nombre déterminé de modules amplificateurs (1i) à transistors par un signal de modulation (A(t)), caractérisé en ce qu'il consiste à décomposer le signal radiofréquence à moduler suivant au moins un premier et un deuxième signal ($V_1$(t) et $V_2$(t)), représentant respectivement la somme des tensions de sortie ($v_1$(t), $v_2$(t)) d'amplitudes respectives identiques ($E_1$, $E_2$) d'un premier et d'un deuxième nombre déterminé de modules (23 et 24), auxquels sont associés respectivement un premier et un deuxième vecteur ($\vec{V}_1$ et $\vec{V}_2$) dont les amplitudes ($E_1$, $E_2$) et les phases ($\varphi_1$,$\varphi_2$) respectives vérifient que la somme vectorielle ($\vec{V}_S$) des deux vecteurs ($\vec{V}_1$ et $\vec{V}_2$) coïncide avec une référence ($\vec{V}$réf) déterminée servant de référence de phase des deux vecteurs ($\vec{V}_1$ et $\vec{V}_2$), et à moduler les phases ($\varphi_1$,$\varphi_2$) respectives des deux signaux ($V_1$(t) et $V_2$(t)) par le signal de modulation et, à additionner le premier et le deuxième signal ($V_1$(t) et $V_2$(t)) modulés en phase pour obtenir après filtrage un signal résultant ($V_S$*(t)) modulé en amplitude.

2. Procédé selon la revendication 1, caractérisé en ce qu'il consiste en outre à adapter la phase ($\phi$) de l'impédance de charge de chaque module pour que le vecteur ($\vec{I}$) associé au courant débité par chacun des modules amplificateurs soit en retard de phase par rapport à leurs tensions de sortie.

3. Dispositif pour la mise en oeuvre du procédé selon l'une quelconque des revendications 1 et 2, caractérisé en ce qu'il comporte des moyens d'amplification (22), des moyens (5) pour générer des commandes de modulation de phase en fonction de l'amplitude du signal de modulation (A(t)) sur les moyens d'amplification (22), des moyens de gestion (6) pour gérer les commandes de modulation de phase et d'amplitude des moyens d'amplification (22) en fonction de l'amplitude du signal de modulation (A(t)), des moyens (21) pour répartir les signaux de commande de modulation de phase et d'amplitude sur les moyens d'amplification (22) en fonction des commandes issues des moyens de gestion (6), des moyens (25) pour additionner les signaux de sortie ($V_1$(t) et $V_2$(t)) des moyens d'amplification (22) et, des moyens de filtrage (29) pour obtenir en sortie un signal radiofréquence ($V_S$*(t)) modulé en amplitude.

4. Dispositif selon la revendication 3, caractérisé en ce que les moyens d'amplification (22) comportent un nombre déterminé de modules amplificateurs (1i) générant chacun une tension ($v_1$(t), $v_2$(t)), d'amplitude et de phase déterminées, aux bornes d'une charge de sortie (Z).

5. Dispositif selon la revendication 4, caractérisé en ce qu'un module amplificateur (1i) comporte une structure symétrique de pont en "H" comportant quatre transistors MOSFET ($T_1$ à $T_4$) répartis chacun sur chaque branche du pont fonctionnant en régime de commutation de blocage, recevant chacun sur leur grille (G) un signal de commande radiofréquence (RF1, RF2) et dont l'alimentation (E) est commandée par une commande d'activation ou de non activation (ON/OFF).

6. Dispositif selon l'une quelconque des revendications 3 à 5, caractérisé en ce que les moyens (5) pour générer les commandes de modulation de phase comportent, au moins un premier et un deuxième circuit de traitement numérique (7 et 8) du signal de modulation (A(t)) déterminant respectivement la valeur du déphasage ($\varphi_1$,$\varphi_2$) à appliquer respectivement au premier et au deuxième signal de sortie ($V_1$(t) et $V_2$(t)) d'un premier et d'un deuxième nombre déterminé (23 et 24) de modules amplificateurs (1i) des moyens d'amplification (22) en fonction de l'amplitude du signal de modulation (A(t)), un registre tampon (9) pour synchroniser les données de modulation de phase issues respectivement des deux circuits de traitement numérique (7 et 8), au moins un premier et un deuxième oscillateur numérique (10 et 11) générant respectivement à partir d'un même signal d'horloge déterminé (H) un signal numérique périodique variant sinusoïdalement à la fréquence d'émission (f) du signal à moduler et dont la phase ($\varphi_1$,$\varphi_2$) varie suivant la commande de modulation de phase issue respectivement des deux circuits de traitement numérique (7 et 8), couplés respectivement à un convertisseur numérique-analogique (12 et 13) dont la sortie est couplée à un filtre (14 et 15), pour délivrer en sortie, respectivement, un signal de commande (RF1, RF2) de phase déterminée ($\varphi_1$,$\varphi_2$) en fonction de l'amplitude du signal de modulation ((A(t)) et de fréquence identique à la fréquence d'émission (f).

7. Dispositif selon l'une quelconque des revendications 3 à 6, caractérisé en ce que les moyens de gestion comportent un circuit de traitement de séquences (16), chaque séquence étant définie comme une portion du signal de modulation (A(t)), recevant sur une première entrée le signal de modulation (A(t)) converti numériquement et délivrant en sortie des informations respectives à la pente du signal de modulation (A(t)) à l'instant courant (t) et à l'instant précédent (t-1), des informations respectives à l'identification du premier et du dernier module activé à chaque changement de pente du signal de modulation (A(t)), ces informations étant réinjectées sur ses autres entrées, et délivrant en outre un premier couple d'informations respectives à l'identification du module élu par le circuit de traitement (16) et à la phase à appliquer sur le module élu, et un deuxième couple d'informations respectives à l'identification du module élu et à la pente du signal de modulation, un décodeur de phase (18) et un décodeur d'état ON/OFF (19) recevant respectivement le premier et le deuxième couple d'informations, et un registre tampon (20) pour synchroniser les informations décodées par les deux décodeurs (18 et 19) et délivrant respectivement un mot déterminé de commande sur un multiplexeur (21) et un mot déterminé de commande (ON/OFF) de l'étage amplificateur (22).

8. Dispositif selon l'une quelconque des revendications 3 à 7, caractérisé en ce que les moyens (25) pour additionner les signaux de sortie ($V_1$(t) et $V_2$(t)) des moyens d'amplification (22) comportent au moins deux transformateurs (26i) dont les primaires (27i) reçoivent respectivement les signaux de sortie du premier et du deuxième nombre déterminé de modules et dont les secondaires (28i) sont câblés en série, une première extrémité étant reliée à un potentiel de référence (M) et une deuxième extrémité étant reliée à l'entrée des moyens de filtrages (29).

**Patentansprüche**

1. Verfahren zur Amplitudenmodulation eines Signals, bei dem ein Hochfrequenzsignal ($V_S$(t)) am Ausgang einer bestimmten Anzahl von Verstärkermoduln (1i) mit Transistoren durch ein Modulationssignal (A(t)) moduliert wird, dadurch gekennzeichnet, daß das zu modulierende Hochfrequenzsignal gemäß mindestens einem ersten und einem zweiten Signal ($V_1$(t) und $V_2$(t) zerlegt wird, die die Summe der Ausgangsspannungen ($v_1$(t), $v_2$(t)) gleicher Amplituden ($E_1$, $E_2$) einer ersten beziehungsweise zweiten bestimmten Anzahl von Moduln (23, 24) bilden, denen ein erster beziehungsweise zweiter Vektor ($\vec{V}_1$, $\vec{V}_2$) zugeordnet ist, deren Amplituden ($E_1$, $E_2$) und Phasen ($\varphi_1$, $\varphi_2$) berücksichtigen, daß die Vektorsumme ( $\vec{V}_S$) der beiden Vektoren ($\vec{V}_1$, $\vec{V}_2$) mit einem bestimmten Bezugswert ($\vec{V}_{ref}$) zusammenfällt, der als Phasenbezugswert der beiden Vektoren ($\vec{V}_1$, $\vec{V}_2$) dient, und daß die Phasen ($\varphi_1$, $\varphi_2$) der beiden Signale ($V_1$(t), $V_2$(t)) mit dem Modulationssignal moduliert werden, worauf die beiden phasenmodulierten Signale ($V_1$(t), $V_2$(t)) addiert werden, um nach einer Filterung ein resultierendes Signal ($V_S^*$ (t)) zu ergeben, das amplitudenmoduliert ist.

2. Verfahren nach Anspruch 1, dadurch gekennzeichnet, daß außerdem die Phase ($\phi$) der Lastimpedanz

jedes Moduls so angepaßt wird, daß der Vektor, ( $\vec{I}$), der dem von jedem Verstärkermodul abgegebenen Strom zugeordnet ist, bezüglich ihrer Ausgangsspannung phasenmäßig nacheilt.

3. Vorrichtung zur Durchführung des Verfahrens nach einem der Ansprüche 1 und 2, dadurch gekennzeichnet, daß sie Verstärkungsmittel (22), Mittel (5) zur Erzeugung von Phasenmodulationssteuerungen abhängig von der Amplitude des Modulationssignals (A(t)) für die Verstärkungsmittel (22), Mittel (6) zur Bearbeitung der Phasen- und Amplitudenmodulationssteuerungen für die Verstärkungsmittel (22) abhängig von der Amplitude des Modulationssignals (A(t)), Mittel (21) zur Verteilung der Steuersignale für die Phasen- und Amplitudenmodulation auf die Verstärkungsmittel (22) abhängig von Steuerungen, die von den Bearbeitungsmitteln (6) stammen, Mittel (25), um die Ausgangssignale ($V_1$(t), $V_2$(t)) der Verstärkungsmittel (22) zu addieren, und Filtermittel (29) aufweist, um am Ausgang ein amplitudenmoduliertes Hochfrequenzsignal ($V_S^*$(t)) zu erhalten.

4. Vorrichtung nach Anspruch 3, dadurch gekennzeichnet, daß die Verstärkungsmittel (22) eine bestimmte Anzahl von Verstärkermoduln (1i) enthalten, die je eine Spannung ($v_1$(t), $v_2$(t)) bestimmter Amplitude und bestimmter Phase an die Klemmen der Ausgangslast (Z) liefern.

5. Vorrichtung nach Anspruch 4, dadurch gekennzeichnet, daß ein Verstärkermodul (li) eine symmetrische Brückenstruktur in Form eines H mit vier MOSFET-Transistoren ($T_1$ bis $T_4$) aufweist, die auf die vier Zweige der Brücke verteilt sind, im Sperrschaltbetrieb arbeiten, je an ihrem Gate (G) ein Hochfrequenz-Steuersignal (RF1, RF2) empfangen, wobei die Brücke über einer ON/OFF-Steuerung gespeist wird.

6. Vorrichtung nach einem beliebigen der Ansprüche 3 bis 5, dadurch gekennzeichnet, daß die Mittel (5) zur Erzeugung der Phasenmodulationssteuerungen mindestens eine erste und eine zweite Schaltung (7, 8) für die digitale Verarbeitung des Modulationssignals (A(t)), die den Wert der an das erste beziehungsweise zweite Ausgangssignal ($V_1$(t), $V_2$(t)) einer ersten bzw. zweiten bestimmten Zahl (23, 24) von Verstärkermoduln (1i) der Verstärkungsmittel (22) anzuwendenden Phasenverschiebung ($\varphi_1$, $\varphi_2$) abhängig von der Amplitude des Modulationssignals (A(t)) bestimmen, ein Pufferregister (9) zur Synchronisierung der von den beiden digitalen Verarbeitungsschaltungen (7, 8) kommenden Phasenmodulationsdaten, und mindestens einen ersten und einen zweiten digitalen Oszillator (10, 11) aufweisen, die aus einem gemeinsamen Taktsignal (H) je ein periodisches digitales Signal erzeugen, das mit der Sendefrequenz (f) des zu modulierenden Signals sinusförmig variiert und dessen Phase ($\varphi_1$, $\varphi_2$) gemäß der Phasenmodulationssteuerung variiert, die von je einer der digitalen Verarbeitungsschaltungen (7, 8) stammen, wobei die beiden Oszillatoren (10, 11) je mit einem Digital-Analogwandler (12, 13) gekoppelt sind, dessen Ausgang mit je einem Filter (14, 15) gekoppelt ist, um ausgangsseitig je ein Steuersignal (RF1, RF2) bestimmter Phase ($\varphi_1$, $\varphi_2$) abhängig von der Amplitude des Modulationssignals (A(t)) und gleicher Frequenz wie die Sendefrequenz (f) zu liefern.

7. Vorrichtung nach einem beliebigen der Ansprüche 3 bis 6, dadurch gekennzeichnet, daß die Bearbeitungsmittel eine Schaltung (16) zur Bearbeitung von je als ein Teil des Modulationssignals (A(t)) definierten Sequenzen aufweisen, die an einem ersten Eingang das in digitale Form umgewandelte Modulationssignal (A(t)) empfängt und am Ausgang Informationen bezüglich der Steigung des Modulationssignals (A(t)) im jeweilig laufenden Zeitpunkt (t) bzw. im vorhergehenden Zeitpunkt (t-1), sowie Informationen bezüglich der Identifizierung des ersten und des letzten aktivierten Moduls bei jedem Wechsel der Steigung des Modulationssignals (A(t)), wobei diese Informationen an die anderen Eingänge der Bearbeitungsmittel zurückgeführt werden, und außerdem ein erstes Paar von Informationen bezüglich der Identifizierung des von der Verarbeitungsschaltung gewählten Moduls sowie ein zweites Paar von Informationen bezüglich der Identifizierung des gewählten Moduls und der Steigung des Modulationssignals liefert, und daß die Bearbeitungsmittel weiter einen Phasendekoder (18) und einen ON/OFF-Zustandsdekoder, die das erste bzw. zweite Paar von Informationen empfangen, und ein Pufferregister (20) aufweisen, das die von den Dekodern (18, 19) dekodierten Informationen synchronisiert und ein bestimmtes Steuerwort an einen Multiplexer (21) sowie ein bestimmtes Steuerwort (ON/OFF) an die Verstärkungsstufe (22) liefert.

8. Vorrichtung nach einem beliebigen der Ansprüche 3 bis 7, dadurch gekennzeichnet, daß die Mittel (25) zum Addieren der Ausgangssignale (V$_1$(t), V$_2$(t)) der Verstärkungsmittel mindestens zwei Transformatoren (26i) aufweisen, deren Primärwicklungen (27i) die Ausgangssignale der ersten bzw. zweiten bestimmten Anzahl von Moduln empfangen und deren Sekundärwicklungen (28i) in Reihe geschaltet sind, wobei ein erstes Ende an ein Bezugspotential (M) und ein zweites Ende an den Eingang der Filtermittel (29) angeschlossen ist.

**Claims**

1. Method for amplitude modulation of a signal, of the type consisting in modulating an output radiofrequency signal ($V_S$(t)) of a determined number of amplifier modules (1i) having transistors, with a modulation signal (A(t)), characterized in that it consists in decomposing the radiofrequency signal to be modulated into at least a first and a second signal ($V_1$(t) and $V_2$(t)), respectively representing the sum of the output voltages ($v_1$(t), $v_2$(t)) of identical respective amplitudes ($E_1$, $E_2$) of a first and of a second determined number of modules (23 and 24), with which a first and a second vector ($\vec{V}_1$ and $\vec{V}_2$) are respectively associated, the respective amplitudes ($E_1$, $E_2$) and phases ($\phi_1$, $\phi_2$) of which satisfy the condition that the vector sum ($\vec{V}_S$) of the two vectors ($\vec{V}_1$ and $\vec{V}_2$) coincides with a determined reference ($\vec{V}_{ref}$) used as a phase reference for the two vectors ($\vec{V}_1$ and $\vec{V}_2$), and in modulating the respective phases ($\phi_1$, $\phi_2$) of the two signals ($V_1$(t) and $V_2$(t)) with the modulation signal, and in adding the first and second phase-modulated signals ($V_1$(t) and $V_2$(t)) in order, after filtering, to obtain an amplitude-modulated resultant signal ($V_S^*$(t)).

2. Method according to Claim 1, characterized in that it furthermore consists in matching the phase ($\phi$) of the load impedance of each module so that the vector ($\vec{I}$) associated with the current delivered by each of the amplifier modules is in phase lag relative to their output voltages.

3. Device for implementing the method according to either one of Claims 1 and 2, characterized in that it includes amplification means (22), means (5) for generating phase-modulation commands as a function of the amplitude of the modulation signal (A(t)) for the amplification means (22), management means (6) for managing the phase-modulation and amplitude-modulation commands of the amplification means (22) as a function of the amplitude of the modulation signal (A(t)), means (21) for distributing the phase-modulation and amplitude-modulation control signals for the amplification means (22) as a function of the commands output by the management means (6), means (25) for adding the output signals ($V_1$(t) and $V_2$(t)) of the amplification means (22), and filtering means (29) for obtaining an amplitude-modulated radiofrequency signal ($V_S^*$(t)) as output.

4. Device according to Claim 3, characterized in that the amplification means (22) include a determined number of amplifier modules (1i), each generating a voltage ($v_1$(t), $v_2$(t)), of determined amplitude and phase, across the terminals of an output load (Z).

**5.** Device according to Claim 4, characterized in that an amplifier module (1i) includes a symmetrical "H" bridge structure including four MOSFET transistors ($T_1$ to $T_4$), each distributed over each branch of the bridge operating in off-state switching mode, each receiving on their gate (G) a radiofrequency control signal (RF1, RF2) and having their supply (E) controlled by an activation or deactivation command (ON/OFF).

**6.** Device according to any one of Claims 3 to 5, characterized in that the means (5) for generating the phase-modulation commands include at least a first and a second digital processing circuit (7 and 8) for the modulation signal (A(t)), respectively determining the value of the phase shift ($\phi_1$, $\phi_2$) to be applied respectively to the first and to the second output signal ($V_1(t)$ and $V_2(t)$) of a first and of a second determined number (23 and 24) of amplifier modules (Ii) of the amplification means (22) as a function of the amplitude of the modulation signal (A(t)), a buffer register (9) for synchronizing the phase-modulation data output respectively by the two digital processing circuits (7 and 8), at least a first and a second numerically controlled oscillator (10 and 11), respectively generating, on the basis of the same determined clock signal (H), a periodic digital signal which varies sinusoidally at the transmission frequency (f) of the signal to be modulated and whose phase ($\phi_1$, $\phi_2$) varies according to the phase-modulation command output respectively by the two digital processing circuits (7 and 8), these oscillators being respectively coupled to a digital/analog converter (12 and 13) whose output is coupled to a filter (14 and 15) for respectively delivering as output a control signal (RF1, RF2) of determined phase ($\phi_1$, $\phi_2$) as a function of the amplitude of the modulation signal (A(t)) and of identical frequency to the transmission frequency (f).

**7.** Device according to any one of Claims 3 to 6, characterized in that the management means include a sequence processing circuit (16), each sequence being defined as a portion of the modulation signal (A(t)), receiving the digitally converted modulation signal (A(t)) on a first input and delivering, as output, information relating to the slope of the modulation signal (A(t)) at the current instant (t) and at the preceding instant (t-1), information relating to the identification of the first and of the last module activated at each change of slope of the modulation signal (A(t)), this information being re-input on its other inputs, and furthermore delivering a first pair of information items relating to the identification of the module chosen by the processing circuit (16) and to the phase to be applied to the chosen module, and a second pair of information items relating to the identification of the chosen module and to the slope of the modulation signal, a phase decoder (18) and an ON/OFF state decoder (19), respectively receiving the first and second pairs of information items, and a buffer register (20) for synchronizing the information decoded by the two decoders (18 and 19) and respectively delivering a determined command word for a multiplexer (21) and a determined command word (ON/OFF) of the amplifier stage (22).

**8.** Device according to any one of Claims 3 to 7, characterized in that the means (25) for adding the output signals ($V_1(t)$ and $V_2(t)$) of the amplification means (22) include at least two transformers (26i), the primaries (27i) of which respectively receive the output signals of the first and of the second determined number of modules and the secondaries (28i) of which are wired in series, a first end being connected to a reference potential (M) and a second end being connected to the input of the filtering means (29).

Plage de variation de $\varphi 2$

Plage de variation de $\varphi 1$

$\omega_{RF}$

FIG.1

+E

INVER-SEUR  2

T1  G  D  S  K  D1

T3  K  D3  D  G  S

RF

A  i  $U_Z$  B

T2  G  D  S  K  D2  Z  K  D4  T4  D  G  S

INVER-SEUR  3

RF

M

ON / OFF

FIG.2

FIG.3

FIG.4